# EUROPÄISCHE PATENTSCHRIFT

(11) **EP 3 446 023 B1**
(45) Veröffentlichungstag und Bekanntmachung des Hinweises auf die Patenterteilung: **15.07.2020**
(21) Anmeldenummer: 16722784.2
(22) Anmeldetag: 19.04.2016
(51) Int. Cl.: F16M 13/00, H04M 1/02

(54) **HALTEVORRICHTUNG ZUR AUFNAHME EINES ELEKTRONIKGERÄTS**
HOLDING APPARATUS FOR RECEIVING AN ELECTRONIC DEVICE
DISPOSITIF DE RETENUE DESTINÉ À RECEVOIR UN APPAREIL ÉLECTRONIQUE

(43) Veröffentlichungstag der Anmeldung: 27.02.2019
(73) Patentinhaber: paragon GmbH & Co. KGaA, 33129 Delbrück (DE)
(72) Erfinder: HAGENKAMP, Norbert, 59505 Bad Sassendorf (DE)
(74) Vertreter: Lelgemann, Karl-Heinz
(86) Internationale Anmeldenummer: PCT/EP2016/000638
(87) Internationale Veröffentlichungsnummer: WO 2017/182045

(56) Entgegenhaltungen:
- US-A1- 2006 165 230
- US-A1- 2010 287 810
- US-A1- 2014 325 818
- US-B1- 8 191 852

## Beschreibung

Die Erfindung bezieht sich auf eine Haltevorrichtung zur Aufnahme eines Elektronikgeräts, z.B. eines Mobiltelefons, Smartphones, Tablet-Computers, Abspielgeräts etc., mit einer Ablagefläche, auf der das Elektronikgerät , wie z.B. aus der US 8 191 852 bekannt, ablegbar ist.

Derartige Haltevorrichtungen kommen vergleichsweise häufig in Kraftfahrzeugen zum Einsatz, sind jedoch auch an Motorrädern mehr und mehr üblich geworden.

Da sowohl Kraftfahrzeuge als auch Motorräder einen erheblich längeren Nutzungszyklus aufweisen als die vorstehend genannten Elektronikgeräte und da derartige Elektronikgeräte mit unterschiedlichsten Abmessungen versehen sind, wurden in der Vergangenheit erhebliche Anstrengungen unternommen, um derartige Haltevorrichtungen mit einem vergleichsweise geringen Aufwand umbauen zu können, wobei beispielsweise die eigentlichen Aufnahmeteile an der Haltevorrichtung austauschbar gestaltet wurden.

Ausgehend von dem vorstehend geschilderten Stand der Technik liegt der Erfindung die Aufgabe zugrunde, eine Haltevorrichtung zur Aufnahme von Elektronikgeräten zur Verfügung zu stellen, mittels der ohne Umbauten od.dgl. Elektronikgeräte mit unterschiedlichen Abmessungen in der Haltevorrichtung fixiert aufnehmbar sind und mittels der ein im Vergleich zum Stand der Technik verbesserter Abfluss von Wärme aus den Elektronikgeräten gewährleistet ist.

Diese Aufgabe wird erfindungsgemäß dadurch gelöst, dass die Ablagefläche verform- und an die mit der Ablagefläche der Haltevorrichtung in Anlage geratende Außenfläche unterschiedlicher Elektronikgeräte anpassbar ist. Durch die Verform- und Anpassbarkeit der Ablagefläche wird zum einen sichergestellt, dass Elektronikgeräte mit unterschiedlichen Abmessungen fixiert innerhalb der Haltevorrichtung aufnehmbar sind. Darüber hinaus ergibt sich aufgrund der Verform- und Anpassbarkeit der Ablagefläche über die gesamte der Ablagefläche gegenüberliegende Außenfläche des Elektronikgeräts eine Anlageberührung, unabhängig davon, ob die betreffende Außenfläche des Elektronikgeräts erhabene oder vertiefte Abschnitte aufweist. Das Entstehen von Luftspalten zwischen der betreffenden Außenfläche des Elektronikgeräts und der Ablagefläche der Haltevorrichtung wird verhindert. Hierdurch wird die Wärmeableitung aus dem Elektronikgerät verbessert.

Gemäß der erfindungsgemäßen Haltevorrichtung wird deren Ablagefläche durch die Oberseite eines plastisch-elastisch verformbaren Formkörpers gebildet. Aufgrund der plastisch-elastischen Verformbarkeit passt sich der Formkörper an. Wenn das Elektronikgerät von der Ablagefläche entfernt wird, bildet sich die durch das Elektronikgerät bewirkte Verformung des Formkörpers zurück.

Wenn der plastisch-elastisch verformbare Formkörper eine Gelmatte bzw. ein Gelpad mit einer Gelpadhaut und einer Gelpadfüllung ist, kann die Gelpadhaut werkstoffmäßig entsprechend dem an sie gestellten Anforderungsprofil und die Gelpadfüllung entsprechend dem an sie gestellten Anforderungsprofil optimiert werden.

Alternativ ist es möglich, die Ablagefläche durch die Oberseite eines flexiblen Flächengebildes, z.B. einer Folie, auszugestalten, wobei auf der Unterseite des flexiblen Flächengebildes plastisch-elastisch verformbarer Werkstoff, insbesondere plastisch-elastisch verformbares Gel, angeordnet ist. Um eine drahtlose elektrische Aufladung von in der Haltevorrichtung aufgenommenen Elektronikgeräten zu ermöglichen, weist die Haltevorrichtung eine Aufladeeinrichtung auf, mittels der das in der Haltevorrichtung angeordnete Elektronikgerät drahtlos aufladbar ist.

Zur Verbesserung der Wärmeabfuhr vom in der Haltevorrichtung aufgenommenen Elektronikgerät ist es zweckmäßig, wenn der plastisch-elastisch verformbare Werkstoff bzw. der plastisch-elastisch verformbare Formkörper einen hohen Wärmeleitkoeffizienten aufweist.

Die an der Haltevorrichtung vorgesehene Aufladeeinrichtung kann zweckmäßigerweise im plastisch-elastisch verformbaren Formkörper bzw. im Gelpad angeordnet sein. Die Aufladeeinrichtung kann jedoch auch an der Haltevorrichtung selbst realisiert werden.

Vorteilhaft weist die Haltevorrichtung ein starres Schalenelement auf, in dem das flexible Flächengebilde gehaltert ist bzw. in dem der Formkörper bzw. das Gelpad aufgenommen ist. Vorteilhaft kann der plastisch-elastisch verformbare Werkstoff zwischen dem vergleichsweise starren Schalenelement und dem an diesem gehalterten flexiblen Flächengebilde angeordnet sein.

Um sicherzustellen, dass eine Aufladung des in der Haltevorrichtung befindlichen Elektronikgeräts mit einem möglichst hohen Wirkungsgrad stattfindet, ist es vorteilhaft, wenn der Formkörper bzw. das Gelpad bzw. das textile Flächengebilde der Haltevorrichtung an der Ablagefläche Markierungen aufweist, mittels denen das Elektronikgerät beim Ablegen auf der Ablagefläche in Bezug auf die Aufladeeinrichtung der Haltevorrichtung positionierbar ist.

Die erfindungsgemäße Haltevorrichtung ist so gestaltbar, dass sie für Motorräder anwendbar ist.

Zweckmäßigerweise weist die Haltevorrichtung einen Deckel auf, der am Schalenelement zwischen einer Öffnungsstellung und einer Schließstellung beweglich, vorzugsweise verschwenkbar, angeordnet ist, und mittels dem in seiner Schließstellung das Elektronikgerät gegen den plastisch-elastisch verformbaren Formkörper bzw. das Gelpad andrück- und fixierbar ist. Hierdurch wird auch bei mechanischen Beanspruchungen, wie Stößen etc., der Haltevorrichtung sichergestellt, dass das Elektronikgerät fixiert innerhalb der Haltevorrichtung verbleibt.

Um trotz des Deckels eine Sichtbarkeit und eine Bedienbarkeit des in der Haltevorrichtung befindlichen Elektronikgeräts sicherzustellen, ist es vorteilhaft, wenn der Deckel an seinem das Elektronikgerät abdeckenden Deckelabschnitt transparent ausgebildet ist.

Im Folgenden wird die Erfindung anhand von Ausführungsformen unter Bezugnahme auf die Zeichnung näher erläutert.

Es zeigen:
- Figur 1: eine Längsschnittdarstellung einer Ausführungsform einer erfindungsgemäßen Haltevorrichtung zur Aufnahme eines Elektronikgeräts;
- Figur 2: einen Formkörper bzw. ein Gelpad der in Figur 1 gezeigten Ausführungsform der erfindungsgemäßen Haltevorrichtung;
- Figur 3: das in Figur 2 gezeigte Gelpad, auf dem ein Elektronikgerät abgelegt ist;
- Figur 4: eine weitere Ausführungsform der erfindungsgemäßen Haltevorrichtung zur Aufnahme eines Elektronikgeräts;
- Figur 5: eine Prinzipdarstellung im Schnitt der erfindungsgemäßen Haltevorrichtung mit einem Gelpad; und
- Figur 6: eine Figur 5 entsprechende Darstellung mit einem Formkörper.

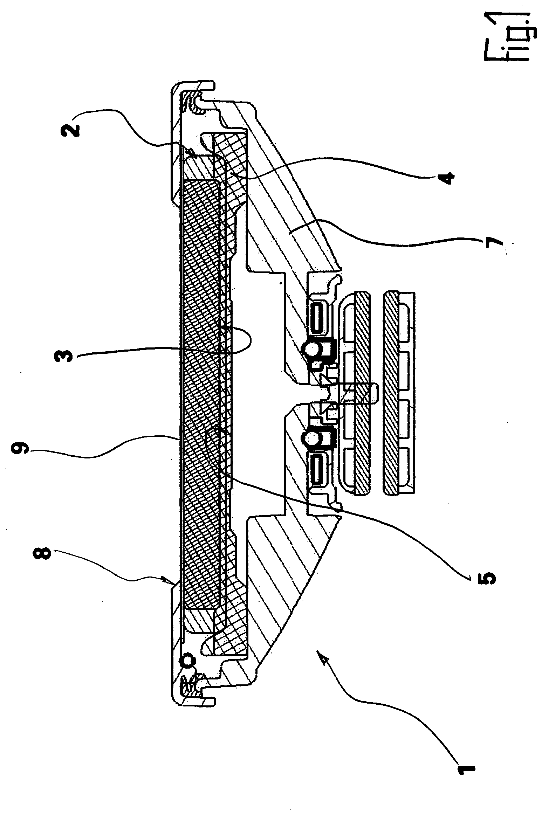

Eine im Folgenden anhand der Figuren 1 bis 6 näher erläuterte Haltevorrichtung 1 dient üblicherweise zur Aufnahme eines Elektronikgeräts, wobei es sich bei dem seitens der Haltevorrichtung 1 aufzunehmenden Elektronikgerät in Falle der dargestellten Ausführungsbeispiele um ein Smartphone 2 handelt.

Anstelle eines Smartphones 2 kann jedoch auch ein andersartiges Elektronikgerät, z.B. ein Mobiltelefon, ein Tablet-Computer, ein Abspielgerät oder ein ähnliches Gerät in der Haltevorrichtung 1 aufgenommen werden.

Zum Ablegen des Smartphones 2 hat die Haltevorrichtung 1 eine Ablagefläche 3, die im Falle der dargestellten Ausführungsbeispiele durch einen plastisch-elastisch verformbaren Formkörper 4 gebildet wird.

Aufgrund der plastisch-elastischen Verformbarkeit des Formkörpers 4 kann sich die entsprechend ebenfalls verformbare Ablagefläche 3 an die mit ihr in Anlage geratende Außenfläche 5 des Smartphones 2 anpassen. Entsprechend bildet sich unabhängig von der konkreten Kontur bzw. Ausgestaltung der Außenfläche 5 des Smartphones 2, das an der betreffenden Außenfläche 5 beispielsweise eine Kamera oder andersartige Vorsprünge, Einbuchtungen etc. aufweisen kann, eine flächige Anlage zwischen der Außenfläche 5 des Smartphones 2 und der Ablagefläche 3 des Formkörpers 4.

Aufgrund der plastisch-elastischen Verformbarkeit des Formkörpers 4 bilden sich vorangegangene Verformungen desselben zurück, sobald das Smartphone 2 aus der Haltevorrichtung 1 entnommen wird.

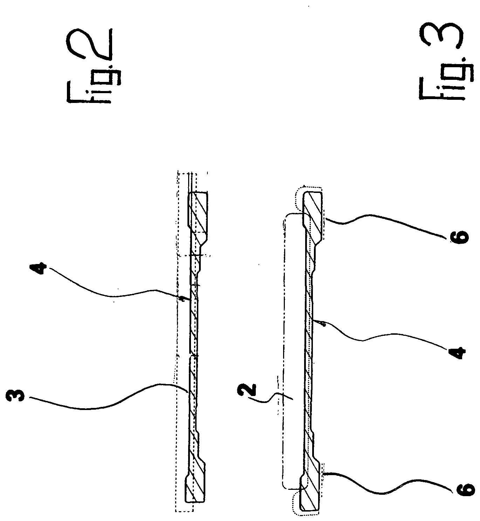

In den Figuren 2 und 3 ist der Formkörper 4 im Schnitt dargestellt. In Figur 2 ist oberhalb bzw. im oberen Bereich des Formkörpers durch die punktierten Linien ein Bereich angedeutet, in den hinein sich der Formkörper 4 verformen kann.

In Figur 3 ist durch die strichpunktierte Linie das Smartphone 2 angedeutet, wobei der Formkörper 4 dann, wenn das Smartphone 2 auf der Ablagefläche 3 abgelegt ist, die in Figur 3 durch die punktierte Linie angedeutete Form einnimmt.

In Figur 3 ist durch zwei gestrichelte Linien eine Klebefläche 6 angedeutet, mittels der der Formkörper 4 mit einem in Figur 1 gezeigten, vergleichsweise starren Schalenelement 7 der Haltevorrichtung 1 verbunden ist.

Auch in Figur 1 ist angedeutet, wie sich der Formkörper 4 beim Auflegen des Smartphones 2 auf die Ablagefläche 3 verformt.

Im dargestellten Ausführungsbeispiel weist die Haltevorrichtung 1 einen an ihr verschwenkbar angebrachten Deckel 8 auf, der zwischen einer Öffnungsstellung und der in Figur 1 gezeigten Schließstellung verstellbar ist. In der Schließstellung drückt der Deckel 8 das Smartphone 2 gegen die Ablagefläche 3 bzw. den Formkörper 4. Hierdurch wird eine flächige Anlage zwischen der Außenfläche 5 des Smartphones 2 und der Ablagefläche 3 des Formkörpers 4 sichergestellt.

Um die Sichtbarkeit und die Bedienbarkeit des Smartphones 2 auch bei geschlossenem Deckel 8 zu gewährleisten, weist der Deckel 8 in seinem das Smartphone 2 abdeckenden Bereich einen transparenten Deckelabschnitt 9 auf.

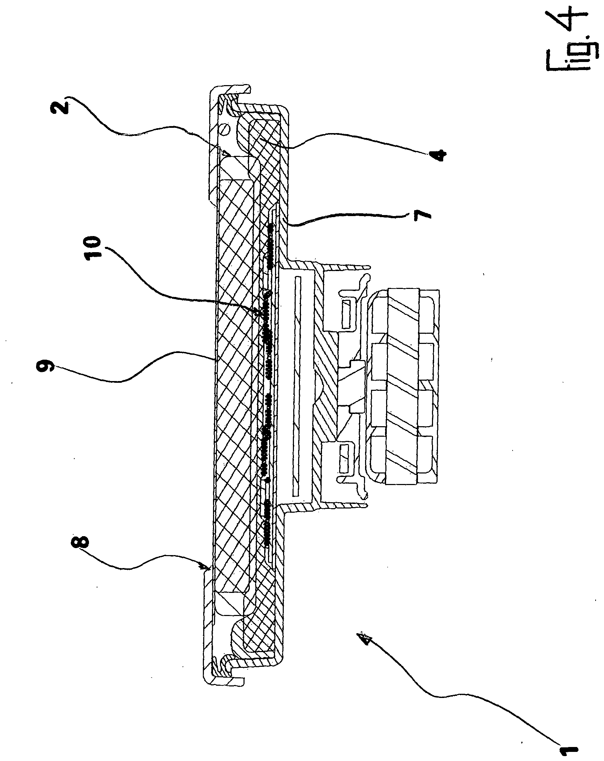

Bei der in Figur 4 gezeigten Ausführungsform der Haltevorrichtung 1 ist diese mit einer Aufladeeinrichtung 10 versehen, mittels der das Smartphone 2, wenn es sich in der Haltevorrichtung 1 befindet, drahtlos aufladbar ist. Der Formkörper 4 ist entsprechend aus einem Werkstoff ausgebildet, der die drahtlose elektrische Aufladung des Smartphones 2 mittels der Aufladeeinrichtung zulässt, ohne dass hier spürbare elektrische Verluste auftreten.

Des Weiteren ist der Formkörper 4 aus einem Werkstoff gestaltet, der einen hohen Wärmeleitkoeffizienten aufweist, so dass beim Aufladevorgang des Smartphones 2 dort entstehende Wärme möglichst schnell durch den Formkörper 4 und das diesen aufnehmende Schalenelement 7 der Haltevorrichtung 1 abgeführt werden kann.

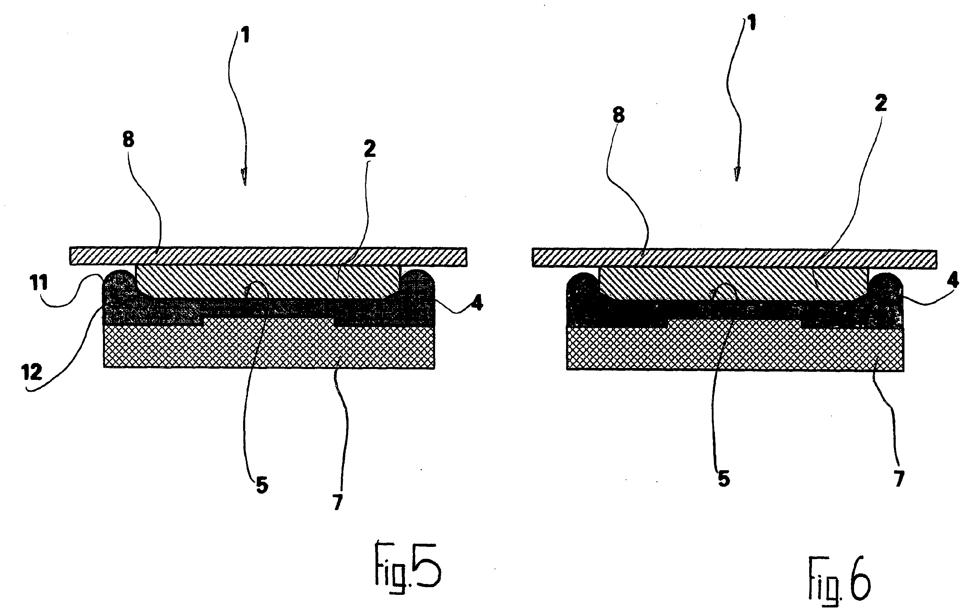

In der Prinzipdarstellung in Figur 5 ist der Formkörper 4 als Gelpad 4 ausgebildet, wobei das Gelpad 4 durch eine Gelpadhaut 11 und eine Gelpadfüllung 12 gebildet ist. Der Werkstoff der Gelpadhaut kann dann hinsichtlich der an diese Gelpadhaut 11 gestellten Ansprüche optimiert werden, wobei entsprechendes auch für den Werkstoff der Gelpadfüllung 12 gilt.

Im Unterschied hierzu ist bei der Darstellung in Figur 6 ein monolithischer Formkörper 4 gezeigt.

Wie sich aus beiden Darstellungen ergibt, wird das Smartphone 2 mittels des Deckels 8 gegen die vom Formkörper bzw. Gelpad 4 gebildete Ablagefläche angedrückt. Die Ablagefläche 3 des Formkörpers bzw. Gelpads 4 liegt dann flächig gegen die betreffende Außenfläche 5 des Smartphones 2 an. Luftspalte od.dgl. zwischen der Ablagefläche 3 und der Außenfläche 5 des Smartphones 2 werden vermieden.

Die Haltevorrichtung 1 kann so gestaltet werden, dass sie als an einem Motorrad einsatzfähige Haltevorrichtung fungieren kann. Bei der Ausgestaltung als Haltevorrichtung 1 für Motorräder ist der Deckel 8 besonders zweckmäßig, da er eine geschützte Aufnahme des Smartphones 2 gewährleistet, wobei aufgrund des transparenten Deckelabschnitts 9 eine Sichtbarkeit des Smartphones 2 gewährleistet ist.

Selbstverständlich kann die vorstehend geschilderte Haltevorrichtung 1 auch im Innenraum von Fahrzeugen zum Einsatz kommen.

## Patentansprüche

1. Haltevorrichtung zur Aufnahme eines Elektronikgeräts, z.B. eines Mobiltelefons, Smartphones (2), Tablet-Computers, Abspielgeräts etc., mit einer Ablagefläche (3), auf der das Elektronikgerät (2) ablegbar ist und die verform- und an die mit der Ablagefläche (3) der Haltevorrichtung (1) in Anlage geratende Außenfläche (5) unterschiedlicher Elektronikgeräte (2) anpassbar ist, wobei die Ablagefläche (3) durch die Oberseite eines plastisch-elastisch verformbaren Formkörpers (4) gebildet ist, **dadurch gekennzeichnet, dass** die Haltevorrichtung eine Aufladeeinrichtung (10) aufweist, mittels der das in der Haltevorrichtung (1) angeordnete Elektronikgerät (2) drahtlos aufladbar ist, und dass die Aufladeeinrichtung (10) im plastisch-elastisch verformbaren Formkörper (4) angeordnet ist.

2. Haltevorrichtung nach Anspruch 1, deren plastisch-elastisch verformbarer Formkörper (4) eine Gelmatte bzw. ein Gelpad (4) mit einer Gelpadhaut (11) und einer Gelpadfüllung (12) ist.

3. Haltevorrichtung nach Anspruch 1, deren Ablagefläche (3) durch die Oberseite eines flexiblen Flächengebildes, z.B. einer Folie, ausgebildet ist, auf dessen Unterseite plastisch-elastisch verformbarer Werkstoff, insbesondere plastisch-elastisch verformbares Gel, angeordnet ist.

4. Haltevorrichtung nach einem der Ansprüche 1 bis 3, deren plastisch-elastisch verformbarer Werkstoff bzw. deren plastisch-elastisch verformbarer Formkörper (4) einen hohen Wärmeleitkoeffizienten aufweist.

5. Haltevorrichtung nach einem der Ansprüche 1 bis 4, die ein starres Schalenelement (7) aufweist, in dem das flexible Flächengebilde gehaltert bzw. der Formkörper (4) bzw. das Gelpad (4) aufgenommen ist.

6. Haltevorrichtung nach Anspruch 5, bei der der plastisch-elastisch verformbare Werkstoff zwischen dem starren Schalenelement (7) und dem an diesem gehalterten flexiblen Flächengebilde angeordnet ist.

7. Haltevorrichtung nach einem der Ansprüche 1 und 4 bis 6, deren Formkörper (4) bzw. Gelpad (4) an der Ablagefläche (3) Markierungen aufweist, mittels denen das Elektronikgerät (2) beim Ablegen auf der Ablagefläche (3) in Bezug auf die Aufladeeinrichtung (10) der Haltevorrichtung (1) positionierbar ist.

8. Haltevorrichtung nach einem der Ansprüche 1 bis 7, die als Haltevorrichtung (1) für Motorräder ausgebildet ist.

9. Haltevorrichtung nach einem der Ansprüche 5 bis 8, die einen Deckel (8) aufweist, der am Schalenelement (7) zwischen einer Öffnungsstellung und einer Schließstellung beweglich, vorzugsweise verschwenkbar, angeordnet ist und mittels dem in seiner Schließstellung das Elektronikgerät (2) gegen den plastisch-elastisch verformbaren Formkörper (4) bzw. das Gel-pad (4) andrück- und fixierbar ist.

10. Haltevorrichtung nach Anspruch 9, deren Deckel (8) an seinem das Elektronikgerät (2) abdeckenden Deckelabschnitt (9) transparent ausgebildet ist.

## Claims

1. A holder for an electronic device, such as a mobile phone, smart phone (2), tablet computer, playback device, etc., comprising a support surface (3), on which the electronic device (2) can be placed and which can deform and adapt to the outer surface (5) of different electronic devices (2) that come into contact with the support surface (3) of the holder (1), which support face is formed by an upper side of a plastical-elastically deformable molded body (4), **characterized in that** the holder comprises a charging device (10) that can wirelessly charge the electronic device (3) in the holder (1) and that the charging device (10) is located in the plastical-elastically deformable molded body (4).

2. The holder according to claim 1, wherein the plastical-elastically deformable molded body (4) is a gel mat or a gel pad (4) with a gel pad skin (11) and a gel-pad filling (12).

3. The holder according to claim 1, wherein the support surface (3) is formed by an upper side of a flexible sheet, for example, a film, on whose lower side is provided plastical-elastically deformable material, in particular, a plastical-elastically deformable gel.

4. The holder according to any one of claims 1 to 3, wherein the plastical-elastically deformable material or the plastical-elastically deformable molded body (4) has a high coefficient of thermal conductivity.

5. The holder according to any one of claims 1 to 4, further comprising a rigid shell (7) in which the flexible sheet is held or the molded body (4) or the gel pad (4) is received.

6. The holder according to claim 5, wherein the plastical-elastically deformable material is between the rigid shell (7) and the flexible sheet held thereon.

7. The holder according to any one of claims 1 and 4 to 6 wherein the molded body (4) or gel pad (4) has markings on the support surface (3) for positioning the electronic device (2) when placed on the support surface (3) with respect to the charging device (10) of the holder (1).

8. The holder according to any one of claims 1 to 7, designed as a holder (1) for motorcycles.

9. The holder according to any one of claims 5 to 8, further comprising a cover (8) on the shell (7) and movable between an open position and a closed position, preferably by pivoting, and that, in its closed position, presses the electronic device (2) against and fixes it to the plastical-elastically deformable molded body (4) or the gel pad (4).

10. The holder according to claim 9, wherein the cover (8) is transparent in a cover section (9) thereof that covers the electronic device (2).

## Revendications

1. Dispositif de retenue pour recevoir un appareil électronique, par exemple un téléphone portable, un smartphone (2), une tablette, un lecteur etc., avec une surface de dépôt (3) sur laquelle l'appareil électronique (2) peut être déposé et laquelle est déformable et adaptable à la surface extérieure (5) venant en butée contre la surface de dépôt (3) du dispositif de retenue (1) de divers appareils électroniques (2), dans lequel la surface de dépôt (3) est formée par la face supérieure d'un corps moulé plastiquement-élastiquement déformable (4), **caractérisé en ce que** le dispositif de retenue présente un moyen de charge (10) à l'aide duquel l'appareil électronique (2) disposé dans le dispositif de retenue (1) peut être rechargé sans fil, et que le moyen de charge (10) est disposé dans le corps moulé plastiquement-élastiquement déformable (4).

2. Dispositif de retenue selon la revendication 1, dont le corps moulé plastiquement-élastiquement déformable (4) est un tapis en gel ou un coussin de gel (4) avec une pellicule de coussin de gel (11) et un rembourrage de coussin de gel (12).

3. Dispositif de retenue selon la revendication 1, dont la surface de dépôt (3) est réalisée par la face supérieure d'une structure plane flexible, par exemple une feuille, sur la face inférieure de laquelle un matériau plastiquement-élastiquement déformable est disposé, en particulier un gel plastiquement-élastiquement déformable.

4. Dispositif de retenue selon l'une des revendications 1 à 3, dont le matériau plastiquement-élastiquement déformable ou dont le corps moulé plastiquement-élastiquement déformable (4) présente un coefficient élevé de conductivité thermique.

5. Dispositif de retenue selon l'une des revendications 1 à 4, lequel présente un élément de coque rigide (7) dans lequel la structure plane flexible est maintenue ou le corps moulé (4) ou coussin de gel (4) est réceptionné.

6. Dispositif de retenue selon la revendication 5, dans lequel le matériau plastiquement-élastiquement déformable est disposé entre l'élément de coque rigide (7) et la structure plane flexible maintenue au niveau de celui-ci.

7. Dispositif de retenue selon l'une des revendications 1 et 4 à 6, dont le corps moulé (4) ou coussin de gel (4) présente des repères au niveau de la surface de dépôt (3) au moyen desquels, lors du dépôt sur la surface de dépôt (3), l'appareil électronique (2) peut être positionné par rapport au moyen de charge (10) du dispositif de retenue (1).

8. Dispositif de retenue selon l'une des revendications 1 à 7, lequel est réalisé en tant que dispositif de retenue (1) pour des motocycles.

9. Dispositif de retenue selon l'une des revendications 5 à 8, lequel présente un couvercle (8) disposé au niveau de l'élément de coque (7) entre une position ouverte et une position fermée, de manière mobile, de préférence pivotante, et au moyen duquel, dans sa position fermée, l'appareil électronique (2) peut être appliqué contre le corps moulé plastiquement-élastiquement déformable (4) ou le coussin de gel (4) et y être fixé.

10. Dispositif de retenue selon la revendication 9, dont le couvercle (8) est réalisé de façon transparente au niveau de sa partie de couvercle (9) recouvrant l'appareil électronique (2).
